# EUROPEAN PATENT SPECIFICATION

(11) **EP 2 138 817 B1**
(45) Date of publication and mention of the grant of the patent: **23.05.2012**
(21) Application number: 09162506.1
(22) Date of filing: 11.06.2009
(51) Int. Cl.: G01J 5/20

(54) **Structures for temperature sensors and infrared detectors having a quantum well structure**
Strukturen für Temperatursensoren und Infrarotdetektoren mit Quantumwellstruktur
Structures pour des capteurs de températures et des détecteurs d'infrarouges avec structure à puits quantiques

(30) Priority: 25.06.2008 SE 0801498
(43) Date of publication of application: 30.12.2009
(73) Proprietor: Acreo AB, 164 40 Kista (SE)
(72) Inventor: Andersson, Jan, 171 42 Solna (SE); Höglund, Linda, 590 46 Rimforsa (SE); Ericsson, Per, 175 67 Järfälla (SE)
(74) Representative: Haag, Malina Anna

(56) References cited:
- EP-A- 1 912 259
- WO-A-97/25600
- US-A- 5 228 777
- CHAKRABARTI S ET AL: "High-performance mid-infrared quantum dot infrared photodetectors; Quantum dot infrared photodetectors" JOURNAL OF PHYSICS D. APPLIED PHYSICS, IOP PUBLISHING, BRISTOL, GB, vol. 38, no. 13, 7 July 2005 (2005-07-07), pages 2135-2141, XP020083179 ISSN: 0022-3727

## Description

The present invention relates to structures for temperature sensors and infrared detectors.

Infrared detectors, abbreviated as "IR detectors", are generally divided into two principal groups: photon detectors and thermal detectors.

Photon detectors are based on IR-absorption leading directly to the excitation of charge carriers, which are subsequently detected electronically. Photon detectors respond rapidly and are sensitive, but they suffer from the disadvantage that they must be cooled to cryogenic temperatures.

Thermal detectors are based on a two-stage process in which IR absorption takes place in a detector structure, which is in this way heated. This change in temperature is detected by means of an integrated temperature sensor. Examples of thermal detectors are resistive bolometers, thermoelectric elements, pn-diodes, pyroelectric sensors, etc. Thermal detectors have the advantage that they can work at room temperature, but they suffer from the disadvantage of having lower sensitivity and lower speed than photon detectors. Sensitivity and speed are not of the greatest importance for detector matrices, and for this reason uncooled thermal detectors are of the greatest interest for detector matrices.

Independently of whether the IR radiation is measured by thermal detectors, which are based on the absorption of IR taking place in a detector structure which is in this way heated, or whether the detector structure is heated by being in heat-conducting contact with a material, the temperature of which is to be measured, the problems experienced with known temperature sensors are the same.

The problems of known temperature sensors, and of thermal detectors of the type mentioned above, are that either the output signal is weak or the level of noise is high, which have the common result that the signal-noise ratio is low.

In order to obtain a high sensitivity, the signal-noise ratio must be sufficiently high. The possibilities of filtering or integrating to remove the noise are limited when measuring rapid temperature changes.

A structure is described in the Swedish patent number 505 753 that gives a high signal-noise ratio.

A structure for temperature sensors and infrared detectors is described in the said patent built up on a substrate that comprises a thermistor layer, the resistance of which depends on temperature, and that comprises electrical contact layers on the two sides of the thermistor layer, where it is intended that the resistance between the contact layers is to be measured. The invention according to the said patent is characterised in that the thermistor layer is constituted by a monocrystalline quantum well structure that comprises alternate quantum well layers and barrier layers. It is specified as an embodiment that the thermistor layer comprises fifty quantum well layers.

EP 1 912 259 relates to a quantum dot thermistor structure and use thereof. The thermistor is built up of layers of quantum well dots surrounded by a barrier material. A contact layer is provided at the lowermost barrier layer and the uppermost barrier layer.

Temperature coefficients greater than 4% can be obtained when GaAs is used for the quantum well layers and AlGaAs is used for the barrier layers. Such detectors, however, are relatively expensive.

A cheaper detector material is a thermistor layer that comprises SiGe as quantum well material and Si as barrier layer material. A problem arises, however, when a thermistor layer with a large number of quantum well layers is to be grown using SiGe/Si material. This is a result of the fact that SiGe has a lattice constant that differs from that of Si, which leads in turn to the incorporation of mechanical stresses that cause the structure to break. For this reason, only a limited number of quantum well layers with intermediate barrier layers can be grown using SiGe/Si material.

On the other hand, the quantum wells become overfilled with charge carriers if the number of quantum well layers is low, less than, for example, twenty. This will lead to the Fermi energy being located at a relatively high level in the quantum wells, which in turn leads to the temperature coefficient, and the ohmic resistance, being lower.

The present invention solves this problem and allows the construction of a detector with a thermistor layer that comprises few quantum well layers. Such a detector has, despite this, a high temperature coefficient.

The present invention thus relates to a structure for temperature sensors and infrared detectors in the form of thermal detectors built up on a substrate that comprises a thermistor layer, the resistance of which depends on temperature, and comprising an electrical contact layer on the two sides of the thermistor layer, where it is intended that the resistance between these contact layers is to be measured, where the thermistor layer is constituted by a monocrystalline quantum well structure that comprises alternate quantum well layers and barrier layers, where the substrate consists of a disc of silicon, where the quantum well layers consist of silicon-germanium, SiGe, that has been p-doped, and where the barrier layers consist of undoped or low-doped silicon, Si, characterised in that buffer layers are present between the two said contact layers and the thermistor layer, arranged to prevent the contact layers from overfilling the quantum wells in the thermistor layer and in that the thermistor layer has a number of quantum well layers that does not exceed 20.

The term "quantum well layer" is here used to denote continuous layers. Other epitaxial layers such as so called "quantum dots" may be used instead of quantum well layers, where quantum dots are three-dimensional regions of quantum well material surrounded by barrier layer material, where the quantum dots surrounded by the barrier layer material form layers, which in turn are surrounded by barrier layers on their two sides. Such quantum dots are described in the European patent number EP 1 912 259.

The invention is described in more detail below, partially in association with an embodiment of the invention shown in the drawings, where:
- Figure 1 shows a band diagram for quantum wells, and
- Figure 2 shows schematically the design of a detector according to the invention.

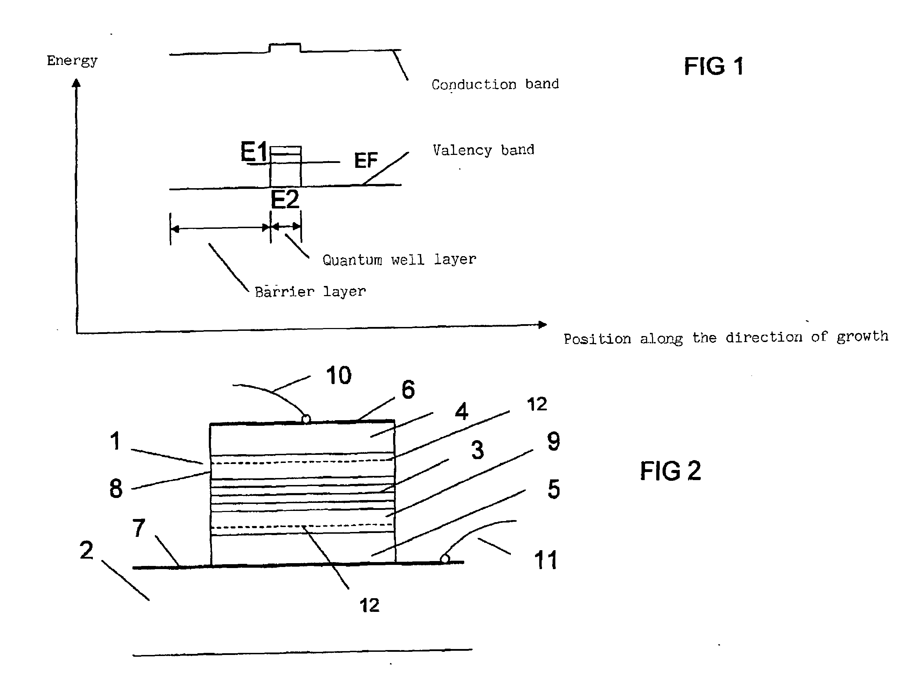

The term "quantum well" is here used to denote thin layers of semi-conductors, which are known as "quantum well layers", in which charge carriers have energies that are lower than in the surrounding layers, which are known as "barrier layers". Quantum well layers and barrier layers are both monocrystalline and they have lattices that are commensurate with each other. Energy quantisation will arise if the quantum well layers are thin, and this will influence the allowed energy levels of the charge carriers. Figure 1 shows how the energies of the band edges vary with the position parallel to the direction of growth of a quantum well structure.

The general expression for the temperature coefficient of a detector of thermistor material of quantum well type is: B = (E2-EF)/kT², where E2-EF is the activation energy (see Figure 1), k is Boltzmann's constant, and T is the temperature. EF is the Fermi energy, which can be said to constitute the boundary between a region that is populated by charge carriers and a region that is not populated.

The activation energy depends on the energy gap between the barrier energy and the Fermi level. The energy gap is controlled using the level of doping, the thickness of the well and the height of the energy barrier that confines holes in the well. The broader the well and the lower the level of doping, the higher will be the activation energy required, and this leads to a higher temperature coefficient. The higher the barrier, the higher will be the activation energy required.

Figure 2 shows a structure 1 for temperature sensors and infrared detectors built up on a substrate 2, which structure comprises a thermistor layer 3, the resistance of which depends on temperature, and that comprises an electrical contact layer 4, 5 on the two sides of the thermistor layer 3, where it is intended that the resistance between the contact layers is to be measured. The reference numbers 10 and 11 denote electrical conductors.

According to the invention, buffer layers 8, 9 are present between the said contact layers 4, 5 and the thermistor layer 3, arranged to prevent the contact layers 4, 5 from overfilling the quantum wells in the thermistor layer 3.

According to one preferred embodiment, the buffer layers comprise undoped, or low-doped p-doped silicon. The buffer layers 8, 9 may instead comprise a low-doped, p-doped or undoped SiGe layer.

The contact layers 4, 5 are prevented by these buffer layers 8, 9 from overfilling the quantum wells in the thermistor structure 3 with charge carriers. The protective buffer layers ensure that all quantum wells will be active, which is a requirement for the function of the structure to be reliable. Furthermore, the buffer layers prevent or inhibit the doping substances from diffusing into the thermistor structure.

According to one preferred embodiment, an n-doped layer 12 is present in the buffer layers 8, 9 arranged to constitute barriers against charge carriers migrating from the contact layers 4, 5 to the thermistor layer 3.

The manufacture of such a structure takes place by epitaxy, starting from a monocrystalline substrate 2, on the surface of which new material is grown, whereby the structure is gradually built up, while maintaining the crystal structure. A series of thin and plane quantum well layers and barrier layers can in this way be built up with the layers lying alternately and on top of each other. The quantum well structure is normally manufactured using metalorganic vapour phase epitaxy (MOVPE) or molecular beam epitaxy (MBE).

The thermistor layer 3 has quantum wells of SiGe with a thickness of, for example, 80 Å. The barrier layer of Si may have a thickness of, for example, 350 Å.

The buffer layers 8, 9 consist of low-doped p-type Si, and have a thickness of, for example, 300 nm. The contact layers 4, 5 consist of high-doped p-type Si.

The essential point is that the buffer layers 8, 9 are sufficiently thick to prevent the contact layers 4, 5 from overfilling the quantum wells in the thermistor structure 3 with charge carriers.

The substrate 2 is a disc of silicon.

It is appropriate that the number of quantum well layers in the thermistor layer 3 is at least 5 to 8.

According to the invention, the quantum well structure has a number of quantum well layers that is lower than 20.

According to a further preferred embodiment, the SiGe layers have a maximum thickness in combination with the level of Ge in the layers such that the layers have a lattice that is monocrystalline commensurate with that of silicon. The atomic percentage of Ge in this case is around 35.

The temperature coefficient is optimised with the present invention in that the concentration of charge carriers in the wells is maintained at a low level, with as low an influence from the contact layers as possible.

Furthermore, a structure is obtained with a robust design with a high uniformity of the temperature coefficient. In addition, it is possible to use silicon-based material, which makes it possible to manufacture cheap IR detectors.

The structure according to the invention has proved to have a high temperature coefficient, as high as just above 3%. Furthermore, the detector generates a low level of noise.

A number of different embodiments have been described above. However, the number of quantum well layers in the thermistor layer may be varied, as may the thickness of the various layers.

The present invention, therefore, is not to be regarded as being limited to the embodiments specified above, but it can be varied within the scope specified by the attached patent claims.

## Claims

1. A structure for temperature sensors and infrared detectors in the form of thermal detectors built up on a substrate (2) that comprises a thermistor layer (3), the resistance of which depends on temperature, and comprising an electrical contact layer (4, 5) on the two sides of the thermistor layer (3), where it is intended that the resistance between these contact layers is to be measured, where the thermistor layer (3) is constituted by a monocrystalline quantum well structure that comprises alternate quantum well layers and barrier layers, where the substrate (2) consists of a disc of silicon, where the quantum well layers consist of silicon-germanium, SiGe, that has been p-doped, and where the barrier layers consist of undoped or low-doped silicon, Si, **characterised in that** buffer layers (8, 9) are present between the two said contact layers (4, 5) and the thermistor layer (3), arranged to prevent the contact layers (4, 5) from overfilling the quantum wells in the thermistor layer (3) with charge carriers and **in that** the thermistor layer (3) has a number of quantum well layers that does not exceed 20.

2. A structure according to claim 1, **characterised in that** the buffer layers (8, 9) comprise undoped, or low-doped, p-doped silicon.

3. A structure according to claim 1, **characterised in that** the buffer layers (8, 9) comprise a low-doped, p-doped, or undoped SiGe layers.

4. A structure according to claim 1, 2 or 3, **characterised in that** the quantum well layers, the SiGe layers, have a maximum thickness in combination with the level of Ge in the layer such that the layer has a lattice that is monocrystalline commensurate with that of silicon.

5. A structure according to any one of the preceding claims, **characterised in that** an n-doped layer (12) is present in the buffer layers, arranged to constitute barriers against charge carriers migrating from the contact layers (4, 5) to the thermistor layer (3).

## Patentansprüche

1. Eine Struktur für Temperatursensoren und Infrarotdetektoren in Form von Wärmedetektoren, die auf einem Substrat (2) aufgebaut ist, welches eine Thermistorschicht (3) umfasst, dessen Widerstand von der Temperatur abhängig ist und eine elektrische Kontaktschicht (4, 5) auf beiden Seiten der Thermistorschicht (3) umfasst, wobei beabsichtigt ist, den Widerstand zwischen diesen Kontaktschichten zu messen, wobei die Thermistorschicht (3) aus einer monokristallinen Quantentopfstruktur gebildet ist, die sich abwechselnde Quantentopfschichten und Grenzschichten umfasst, wobei das Substrat (2) aus einer Siliziumscheibe besteht, wobei die Quantentopfschichten aus Silizium-Germanium, SiGe, bestehen, das p-dotiert wurde, und wobei die Grenzschichten aus undotiertem oder gering dotiertem Silizium, Si, bestehen, **dadurch gekennzeichnet, dass** Pufferschichten (8, 9) zwischen den beiden Kontaktschichten (4, 5) und der Thermistorschicht (3) vorhanden sind, um zu verhindern, dass die Kontaktschichten (4, 5) die Quantentöpfe in der Therm istorschicht (3) mit Ladungsträgern überfüllen, und **dadurch gekennzeichnet, dass** die Thermistorschicht (3) eine Anzahl von Quantentopfschichten aufweist, die 20 nicht überschreitet.

2. Struktur nach Anspruch 1, die **dadurch gekennzeichnet ist, dass** die Pufferschichten (8, 9) nicht-dotiertes oder gering-dotiertes, p-dotiertes Silizium umfassen.

3. Struktur nach Anspruch 1, **dadurch gekennzeichnet, dass** die Pufferschichten (8, 9) gering dotierte, p-dotierte oder undotierte SiGe-Schichten umfassen.

4. Struktur nach Anspruch 1, 2 oder 3, **dadurch gekennzeichnet, dass** die Quantentopfschichten, die SiGe-Schichten, eine maximale Dicke in Kombination mit dem Gehalt an Ge in der Schicht aufweisen, so dass die Schicht ein Kristallgitter hat, das monokristallin mit den gleichen Abmessungen wie das von Silizium ist.

5. Struktur nach einem der vorhergehenden Ansprüche, **dadurch gekennzeichnet, dass** eine n-dotierte Schicht (12) in den Pufferschichten vorhanden ist, die so angeordnet ist, dass sie Barrieren gegen Ladungsträger bildet, die von den Kontaktschichten (4, 5) zur Thermistorschicht (3) wandern.

## Revendications

1. Structure pour des capteurs de températures et des détecteurs d'infrarouges sous la forme de détecteurs thermiques accumulés sur un substrat (2) comprenant une couche de thermistance (3), dont la résistance dépend de la température, et comprenant une couche de contact électrique (4, 5) sur les deux côtés de la couche de thermistance (3), dans laquelle la résistance entre ces couche de contact est censée être mesurée, dans laquelle la couche de thermistance (3) est constituée d'une structure de puits quantiques monocristalline comprenant des couches de puits quantiques et des couches de barrières en alternance, dans laquelle le substrat (2) se compose d'un disque de silicium, dans laquelle les couches de puits quantiques se composent de silicium-germanium, SiGe, à dopage de type p, et dans laquelle les couches de barrière se composent de silicium Si sans dopage ou à faible dopage, **caractérisée en ce que** des couches tampon (8, 9) sont présentes entre lesdites deux couches de contact (4, 5) et la couche de thermistance (3), agencées pour empêcher que les couches de contact (4, 5) ne remplissent trop les puits quantiques dans la couche de thermistance (3) avec des porteurs de charges et **en ce que** la couche de thermistance (3) a un nombre de couches de puits quantiques ne dépassant pas 20.

2. Structure selon la revendication 1, **caractérisée en ce que** les couches tampon (8, 9) comprennent du silicium sans dopage ou à faible dopage de type p.

3. Structure selon la revendication 1, **caractérisée en ce que** les couches tampon (8, 9) comprennent des couches de SiGe à faible dopage, à dopage de type p ou sans dopage.

4. Structure selon la revendication 1, 2 ou 3, **caractérisée en ce que** les couches de puits quantiques, les couches de SiGe, ont une épaisseur maximale en relation avec le niveau de Ge dans la couche de sorte que la couche comprenne un treillis monocristallin proportionnel à celui du silicium.

5. Structure selon l'une quelconque des revendications précédentes, **caractérisée en ce qu'**une couche à dopage de type n (12) est présente dans les couches tampon, agencée pour constituer des barrières contre des porteurs de charges en migration des couches de contact (4, 5) vers la couche de thermistance (3).
